# EUROPÄISCHE PATENTSCHRIFT

(11) **EP 0 683 007 B1**
(45) Veröffentlichungstag und Bekanntmachung des Hinweises auf die Patenterteilung: **20.05.1998**
(21) Anmeldenummer: 95105476.6
(22) Anmeldetag: 12.04.1995
(51) Int. Cl.: B23K 26/06

(54) **Materialbearbeitungseinrichtung**
Machining device
Dispositif d'usinage

(30) Priorität: 01.07.1994 DE 4423040; 14.04.1994 EP 94105764
(43) Veröffentlichungstag der Anmeldung: 22.11.1995
(73) Patentinhaber: Carl Zeiss, D-89518 Heidenheim (Brenz) (DE); CARL-ZEISS-STIFTUNG, HANDELND ALS CARL ZEISS, 89518 Heidenheim (Brenz) (DE); Hewlett-Packard GmbH, D-71004 Böblingen (DE)
(72) Erfinder: Schulte in den Bäumen, Joachim, Dr., D-73431 Aalen (DE); Grub, Robert, Dr., D-73560 Böbingen (DE); Gross, Herbert, D-73434 Aalen (DE); Schweizer, Jurgen, Dr., D-73463 Westhausen (DE); Dippon,Siegfrid, D-75391 Gechingen (DE); Tamm, Wilhelm, D-71134 Aidlingen (DE); Lam, Si-Ty, Dr., Pleasanton, CA 94588 (US); Kahlert, Hans-Jürgen, Dr., D-37077 Göttingen (DE); Endert, Heinrich, Dr., D-37217 Witzenhausen-Ermschwerd (DE)

(56) Entgegenhaltungen:
- WO-A-80/02393
- US-A- 5 268 554
- US-A- 5 302 798

## Beschreibung

Die Erfindung betrifft eine Materialbearbeitungseinrichtung gemäß dem Oberbegriff des Anspruchs 1 (siehe DE-A-43 28 894).

Derartige Materialbearbeitungseinrichtungen sind seit langem Stand der Technik. Insbesondere stehen folgende Verfahren zum Erzeugen von feinen Löchern in flexiblen und harten Leiterplatten zur Verfügung.

Mit dem mechanischen Bohren in allgemein bekannter Art und Weise werden mit Spezialbohrmaschinen bis zu mehreren hundert Löchern gleichzeitig in Leiterplatten gebohrt.

Nachteilig ist hierbei, daß wegen der begrenzten mechanischen Stabilität dünner Bohrer der kleinste erzielbare Lochdurchmesser ca. 200 µm beträgt. Außerdem ist nachteilig anzusehen, daß bedingt durch die Konfiguration der Bohrmaschine die Anordnung der Bohrlöcher festliegt. Eine Änderung der Bohrloch-Anordnung erfordert eine zeitaufwendige Umkonfiguration der Bohrmaschine.

Auf photochemischen Weg können Leiterplatten so beschichtet werden, daß die gewünschten Löcher herausgeätzt werden können. Nachteilig ist hierbei der verfahrenstechnische Aufwand des Verfahrens. So müssen die Leiterplatten mehrfach beschichtet und wieder entstrippt (Entfernen der Beschichtung) werden. Weitere Nachteile dieser Bearbeitung sind in der Umweltproblematik der Ätzbäder und in der sich durch das Ätzverfahren ergebende doppelt-sphärische Lochform mit typischer Ätzlippe zu sehen.

Mit Laserstrahlen geeigneter Wellenlänge können über eine laserlichtresistente Maske Löcher in vorbehandelte Leiterplatten "gebohrt" werden. Dabei sind Lochdurchmesser bis wenige µm erreichbar. Dieses Verfahren weist als Nachteil eine feste Anordnung der Bohrlöcher durch die Strukturierung der Maske auf, wodurch eine Änderung der Bohrloch-Anordnung eine andere Maske erfordert.

Bei dem Laser-Einzelstrahlverfahren kann man eine ohne Maske "bohren oder strukturieren". Der Laserstrahl wird einzeln auf diejenige Stelle gelenkt, an welcher man ein Loch wünscht. Der große Nachteil ist hier der Zeitbedarf zur Erzeugung einer Vielzahl von Löchern.

Eine Einrichtung ist z.B. aus der US-PS 5 268 554 bekannt. Dabei wird der Strahl eines Lasers über verschiedene Spiegel fokussierent auf die Oberfläche eines zu bearbeitenden Gegenstandes gebracht. Durch Stellelemente kann die Lage eines Umlenkspiegels in zwei Achsen verändert werden und so der Laserstrahl in einer bestimmten Fläche auf der Oberfläche des zu bearbeitenden Gegenstandes auf diskrete Arbeitspunkte geführt werden. Mehrere Bearbeitungspunkte werden nacheinander bearbeitet. Nachteilig ist außerdem, daß je nach Ablenkung des Laserstrahls der Auftreffpunkt auf der Werkstückoberfläche eine unterschiedliche Größe hat.

Aus der US-PS 5 113 055 ist eine Materialbearbeitungseinrichtung bekannt, bei welchem durch ein optisches System aus mehreren hintereinanderliegenden Spiegelsegmenten wahlweise mehrere Punkte auf einer Werkstückoberfläche nacheinander angefahren werden können.

Aus der US-PS 4 553 017 ist eine Mehrstrahlerzeugungsvorrichtung bekannt, bei welcher aus einem Energiestrahl durch ein Gitter mehrere Strahlen erzeugt werden, deren Foki alle auf einer Linie liegen.

Aus der DE-PS 43 28 894 ist eine weitere Strahlaufteilungseinrichtung für Laserstrahlen bekannt, welche aus einem Laserstrahl zwei diskrete Strahlen erzeugt, welche dann auf zwei Punkte auf der Werkstückoberfläche auftreffen (siehe auch EP-PS 0 360 328, DE-PS 41 11 876, DE-PS 27 08 039 und US-PS 4 623 776).

Aus der US-PS 4 713 518 und der US-PS 5 055 653 sind Materialbearbeitungseinrichtungen bekannt, bei welchen durch mehrere nebeneinanderliegende Linsen in einer Richtung mehrere diskrete Laserstrahlen aus einem Laserstrahl erzeugt werden.

Aus der US-PS 4 950 862 ist eine Materialbearbeitungseinrichtung bekannt, bei welchem ein Laserstrahl durch einen Galvanometerspiegel auf ein Linsenarray gelenkt wird, wobei jeweils eine Linse des Arrays den Strahl auf die Werkstückoberfläche abbildet.

Es ist Aufgabe der Erfindung eine Materialbearbeitungseinrichtung für eine gleichzeitige Bearbeitung an mehreren Punkten auf einer Werkstückoberfläche zu schaffen, wobei aber die Lage der Punkte sich statisch oder dynamisch durch eine steuerbare Ablenkeinrichtung verändern kann.

Diese Aufgabe wird erfindungsgemäß durch die Merkmale des ersten Patentanspruchs gelöst. Weitere vorteilhafte Ausgestaltungen des Erfindungsgedankens sind in den Unteransprüchen beschrieben.

Die Materialbearbeitungseinrichtung zur Bearbeitung einer Oberfläche eines Werkstücks verwendet gleichzeitig mehrere diskrete Bearbeitungsstrahlen, um eine schnellere Bearbeitung auf der Werkstückoberfläche zu ermöglichen.

Jeder Bearbeitungsstrahl wird dabei durch ein ihm zugeordnetes Element einer Ablenkungsanordnung gelenkt, wobei die jeweilige Auslenkung durch eine Steuerungseinrichtung zumindest in einer Achse frei eingestellt werden kann.

Dies ermöglicht die gleichzeitige Bearbeitung möglicherweise unterschiedliche Punkte auf einer Oberfläche eines zu bearbeitenden Gegenstandes.

Dadurch, daß die Lage der einzelnen Elemente der Ablenkungsanordnung durch eine Steuerung gezielt veränderbar ist und die einzelnen Elemente der Ablenkoptik jeweils diskret zumindest in einer Koordinatenrichtung in ihrer Lage versetzbar sind, erhält man weit über den bisherigen Stand der Technik gehende Geschwindigkeiten der Bearbeitung sowie gleichzeitig neue Möglichkeiten, da die Veränderung der Ablenkung sowohl statisch (d.h. jeweils nach einer Bearbeitung) als auch dynamisch (d.h. während der Bearbeitung) erfolgen kann.

Es kann nicht nur eine punktförmige Bearbeitung erfolgen, sondern gleichzeitig können linienhafte Strukturen auf der Werkstückoberfläche erzeugt werden.

Durch die Erfindung ist es möglich, eine wesentlich schnellere Materialbearbeitungseinrichtung zu erhalten, da gleichzeitig an mehreren, frei wählbaren Stellen auf der Oberfläche des Werkstücks gearbeitet werden kann. Diese Stellen brauchen beim nachfolgenden Werkstück nicht an derselben Stelle liegen sondern können frei bestimmt werden.

Wenn die Bearbeitungsstrahlen vor der Ablenkanordnung zueinander parallel angeordnet sind, kann diese vorteilhafter weise in der Bestrahlungsachse verschoben werden, ohne daß dies eine negative Auswirkung auf der Werkstückoberfläche hat.

Um eine kompakte Bearbeitungsanlage zu erhalten,ist es vorteilhaft, wenn die Drehpunkte der Elemente der Ablenkeinrichtung alle in einer Ebene angeordnet sind. Dies hat aber optische Nachteile.

Ordnet man die Elemente der Ablenkeinrichtung hingegen auf einer Parabel an, so verlaufen alle Strahlen im Bearbeitungsraum telezentrisch und sind gleichmäßig verteilt. Diese Vorteile erkauft man sich mit dem Nachteil, daß man eine unterschiedliche Schnittweite pro Strahl erhält, woraus ein Schärfeproblem resultiert.

Dies kann vermieden werden, wenn man die Elemente der Ablenkeinrichtung auf einem zum Fokuspunkt des Scan-Objektives konzentrischen Kreis anordnet und die Oberfläche der Elemente der Ablenkeinrichtung sphärisch gestaltet. Dies hat aber den Nachteil der höheren Kosten. Ein weiteres optisches Problem ist der Astigmatismus.

Wenn die von den Elementen der Ablenkungsanordnung kommenden Bearbeitungsstrahlen zu ihrem jeweiligen Hauptstrahl achsenparallel sind, kann man den zu bearbeitenden Oberflächenbereich frei wählen. Dabei muß aber der Abstand zwischen dem Scan-Objektiv und der zu bearbeitenden Oberfläche fest bleiben.

In der Ablenkungsanordnung können als ablenkende Elemente vorteilhafter weise beugende und/oder reflektierende Elemente verwendet werden. Diese Elemente haben den Vorteil, daß sie mit dem bekanten Stand der Technik sehr kostengünstig hergestellt werden können.

Ist die Ablenkungsanordnung aus reflektierenden Elementen aufgebaut, so können insbesondere elektromagnetische Strahlen sehr gut abgelenkt werden. Diese Strahlenart ist aber bei der Materialbearbeitung sehr wichtig.

Als reflektierende Elemente eignen sich insbesondere Spiegel.

Vorteilhafter weise ist die Ablenkungsanordnung aus Segmenten aufgebaut. Dies erlaubt eine sehr kostengünstige Herstellung.

Dabei sollte jedes der Segmente einzeln in oder um zumindest eine Koordinatenachse beweglich sein. Dies ermöglicht zusätzlich zu einer Lageveränderung auf einer Achse in der Werkstückebene eine Höhenvariation jedes einzelnen Fokusses bezüglich der Werkstückoberfläche.

Vorteilhaft ist, wenn die Segmente in oder um zwei Koordinatenachsen beweglich sind. Dies ermöglicht die Bearbeitung aller Punkte auf der Werkstückoberfläche und nicht nur die Bearbeitung von Punkten auf einer Bearbeitungslinie und zusätzlich eine Höhenvariation des Brennpunktes jedes einzelnen Bearbeitungsstrahls.

Die Oberfläche des reflektierenden Elements kann vorteilhafter weise plan sein, damit mit möglichst geringer Strahlenbeeinflussung sowohl die ankommenden, als auch die reflektierten Strahlenbündel der Bearbeitungsstrahlen einen parallelen Verlauf haben können.

Hinter der Ablenkungseinrichtung sollte vorteilhafter weise eine abbildende Optik angeordnet sein, damit die Bearbeitungsstrahlen möglichst senkrecht auf die zu bearbeitende Oberfläche des Werkstücks einfallen.

Die Oberflächen der Elemente der Ablenkanordnung können aber auch so geformt sein (z.B. bei der Verwendung von Spiegeln), daß ein reflektierter Strahl auf der Oberfläche der Werkstücks durch die Elemente der Ablenkanordnung fokussiert wird. Dann kann auf ein Scan-Objektiv gegebenenfalls verzichtet werden.

Die Bearbeitungsstrahlen sind vorteilhafter weise aus Laserlicht, da für Laserlicht sehr gute Strahlenführungstechniken zu geringen Kosten bekannt sind.

Laserstrahlen haben den weiteren Vorteil, daß sie leicht gelenkt werden können und sich mit preiswerten Optiken verändern läßt. Aber es sind auch alle anderen teilbaren Strahlenbündel verwendbar (z.B. Elektronenstrahlen, Röntgenstrahlen, Sand- oder Wasserstrahlen, usw.).

Insbesondere wenn die Bearbeitungstrahlen aus Laserlicht bestehen, so ist es vorteilhaft, wenn die Anordnung für jeden Bearbeitungsstrahl eine diskrete Ablenkoptik beinhaltet.

Möglich wäre zwar auch eine Ablenkung mittels des optoakustischen Effekts (Dichtevariation in einem Raum mittels Schallwellen), doch liefert dies nicht immer die gewünschte Strahlqualität und auch die Realisierung ist bei entsprechender Miniaturisierung der Anlage sehr schwierig.

Dabei ist es vorteilhaft, wenn in dieser Ablenkanordnung ein beugendes Element enthalten ist. Dies ermöglicht die Verwendung von parallel auf die Ablenkanordnung einfallenden Strahlenbündel, welche erst durch die Ablenkanordnung auf der Oberfläche des Werkstücks fokussiert werden.

Dieses beugende Element befindet sich vorteilhafterweise auf oder hinter einem reflektierenden Element, damit es von vielen Bearbeitungsstrahlen gleichzeitig verwendet werden kann.

Hinter dem Laser sollte vorteilhafter weise ein Strahlhomogenisierer angebracht sein, damit die vom Laser kommende Strahlung für alle Bearbeitungsstrahlen eine gleich große Energiedichte besitzt.Ein derartiger Strahlhomogenisierer ist z.B. aus der DE-PS 39 18 293 bekannt. Mit ihm kann man sicherstellen, daß aus einem Laserstrahl eine erzeugte Vielzahl von Bearbeitungsstrahlen eine gleichgroße Intensität besitzen.

Der Laser wird vorteilhafter weise im gepulsten Betrieb betrieben, da man mit gepulsten Lasern zum einen eine höhere Leistung bei geringerem Aufwand erzielen kann, zum anderen kann man mit gepulsten Strahlen gezielter eine Oberflächenbearbeitung durchführen (Verhinderung der unerwünschten thermischen Nebenwirkungen am Werkstück).

Dabei wird vorteilhafter weise die Intensität eines Laserblitzes so gewählt, daß nur ein Teil des Materials abgetragen wird. Dies erlaubt eine Abtragung der Oberfläche in verschiedenen Ebenen und die Erzeugung von linienhaften Strukturen auf der Oberfläche des zu bearbeitenden Werkstücks.

Wenn eine Strahlaufteilungsanordnung vorhanden ist, welche zumindest einen Bearbeitungsstrahl in mehrere diskrete Bearbeitungsteilstrahlen aufteilt, verringert sich die Anzahl der benötigten Bearbeitungsstrahlenquellen drastisch. Dadurch wird ein starker Strahl in mehrere schwächere Strahlen aufgeteilt, welche jeweils eine ausreichende Energiedichte aufweisen. Dies ermöglicht die Senkung der Kosten für die Erzeugung der Bearbeitungstrahlen.

Vorteilhafter weise ist die Strahlaufteilungsanordnung dabei vor der steuerbaren Ablenkungsanordnung angeordnet.

Einen sehr einfachen Aufbau erhält man, wenn die Strahlaufteilungsanordnung aus mehreren Linsen aufgebaut ist.

Dieser leichte Aufbau wird unterstützt, wenn man die Strahlaufteilungsanordnung aus zwei Arrays aufgebaut, welche dafür sorgen, daß nach der Strahlaufteilungsanordnung die einzelnen Strahlen einen gewissen Abstand zueinander haben.

Um eine Fläche individuell möglichst schnell bearbeiten zu können, ist es vorteilhaft, eine Aufteilung der Bearbeitungsstrahlen flächig zu realisieren. Dabei ist es vorteilhaft, wenn die Strahlaufteilungsanordnung aus einem Array aufgebaut ist, welches eine zweidimensionale Verteilung der erzeugten Teilstrahlen erzeugt.

Hinter der Strahlenaufteilungsanordnung ist vorteilhafter weise ein optisches Vergrößerungssystem angeordnet, um die Dimensionierung des Bearbeitungstrahlenfeldes der Dimensionierung der Ablenkungsanordnung anzupassen..

Die Bearbeitungsstrahlen sollten vorteilhafter weise die Oberfläche von zu bearbeitenden Leiterplatten unter einem Winkel α treffen, welcher nicht zu groß (kleiner als 5°) ist.

Dies erleichtert später die Montage der elektrischen und/oder elektronischen Bauteile.

Die Erfindung wird im folgenden anhand des in den beigefügten Zeichnungen beispielhaft dargestellten Ausführungsbeispiels näher erläutert, wobei weitere, dem besseren Verständnis dienende Erläuterungen und Ausgestaltungsmöglichkeiten beschrieben sind.

Dabei zeigt
- Fig. 1: eine schematische Darstellung der Gesamtkonfiguration;
- Fig. 2: eine Detailansicht des Auffangmaske;
- Fig. 3: eine seitliche Detailansicht der Strahlaufteilungsanordnung;
- Fig. 4: eine Aufsicht auf die Strahlaufteilungsanordnung; und
- Fig. 5: eine Unteransicht eines Elements der Ablenkoptik.

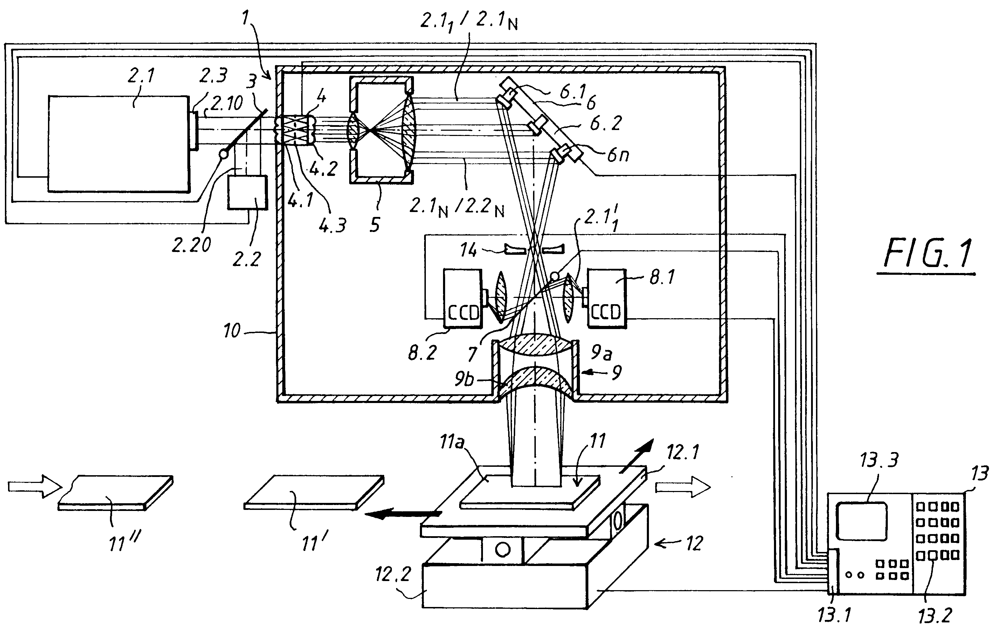

Das in Fig. 1 dargestellte Beispiel einer Realisierung der erfindungsgemäßen Materialbearbeitungseinrichtung (1) dient zur Erzeugung eines Lochmusters auf einer Leiterplatte (11). Derartige Leiterplatten (11) werden in vielen Varianten als Aufbauhilfe und Verbindungsmedium von elektrischen und elektronischen Bauteilen in der Elektronik benötigt.

Wesentlich für die Materialbearbeitungseinrichtung (1) ist, daß sie gleichzeitig mehrere Bearbeitungsstrahlen (2.1₁, ..., 2.1_{N}) hat, welche durch eine steuerbare Anordnung alle auf unterschiedliche, diskrete Punkte auf der Oberfläche (11a) des zu bearbeitenden Gegenstandes (11) gelenkt werden können. Dadurch kann sich das zu erzeugende Loch- oder Linienmuster auf der Oberfläche (11a) der nacheinander zu bearbeitenden Gegenstände (11, 11', 11'', ...) total unterscheiden.

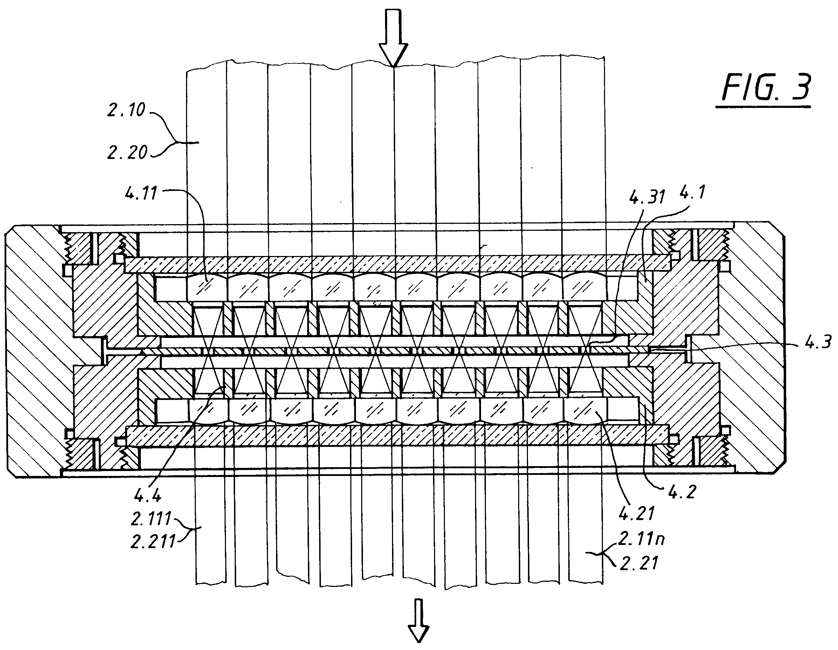

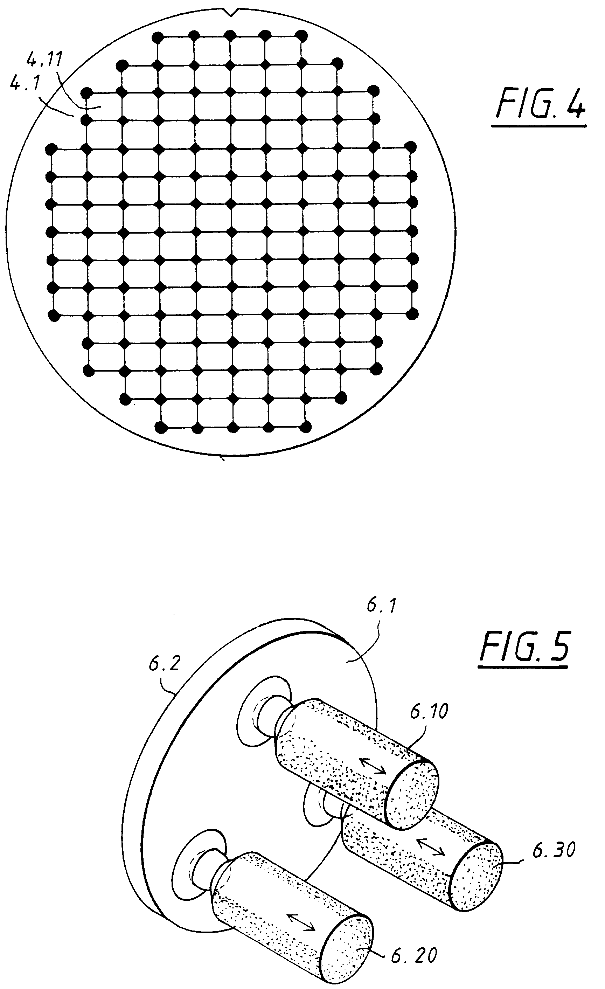

Zur Erzeugung der einzelnen Bearbeitungsstrahlen (2.1₁, ..., 2.1_{N}) besitzt die Bearbeitungseinrichtung (1) einen Laserstrahl-Eingang mit einer als Strahlaufteilungsanordnung (4) genutzten Mikrolinsen-Optik, in welcher aus dem einfallenden Laserstrahl (2.10, 2.20) mit parallelem Strahlenbündel viele Einzelstrahlen (2.1₁, ..., 2.1_{N}) mit parallelen Strahlengängen erzeugt werden. Die Strahlaufteilungsanordnung (4) ist in den Figuren 3 und 4 genauer dargestellt. Sie besteht im wesentlichen aus zwei hintereinander angeordneten Linsenarrays (4.1, 4.2) aus vielen, flächig angeordneten Einzellinsen(4.11, 4.21), zwischen welchen eine Lochblendenplatte (4.3) mit einer entsprechenden Anzahl von Löchern (4.31) angeordnet ist.

Der einfallende Laserstrahl (2.10, 2.20) wird dabei in viele kleine Laserstrahlen ((2.1₁, ..., 2.1_{N}), (2.2₁, ..., 2.2_{N})) zerlegt, welche zueinander einen gewissen räumlichen Abstand haben. Durch eine Veränderung der Linsen (4.21) des hinteren Arrays (4.2) relativ zu den Linsen (4.11) des vorderen Arrays (4.1) kann der Strahldurchmesser der kleinen Laserstrahlen ((2.1₁, ..., 2.1_{N}), (2.2₁, ..., 2.2_{N})) verändert werden. Wenn es gewünscht ist, kann man auch einen oder mehrere Durchmesser der kleinen Laserstrahlen ((2.1₁, ..., 2.1_{N}), (2.2₁, ..., 2.2_{N})) dadurch verändern, indem man in die Stege (4.4) bzw. die ganzen Stege (4.4) als Stellelemente nach dem bekannten Stand der Technik (z.B. Piezostellelemente, Hubkolben, usw.) ausführt. Dadurch erreicht man eine Abstandsänderung zwischen den jeweiligen Linsen (4.11, 4.21) der beiden Linsenarrays (4.1, 4.2).

Je nach Strahlqualität des aus dem Hauptlaser (2.1) kommenden Laserstrahls (2.10) kann dieser vor dem Auftreffen auf diese Strahlenaufteilungsanordnung (4) mit einem Linsenraster (2.3) gemäß der DE-PS 39 18 293 mit einer nachfolgenden Anordnung zum Parallelisieren des Laserstrahls (2.10) in seiner Strahlqualität homogenisiert werden.

Mit dem Laserstrahl (2.10) aus dem Hauptlaser (2.1) kann gleichzeitig der Laserstrahl (2.20) des Markierungslasers (2.2) durch die Strahlenaufteilungsanordnung (4) dringen, welches durch einen Strahlenteiler (3) in den Strahlengang des Hauptlasers (2.1) eingekoppelt wird. Dabei muß dann die Beschichtung des Strahlenteilers (3) so ausgelegt sein, daß der Laserstrahl (2.10) des Hauptlasers (2.1) möglichst ungestört mit möglichst geringem Verlust durch den Strahlenteiler (3) hindurchgeht, während der Laserstrahl (2.20) des Markierungslasers (2.2) möglichst vollständig in den Hauptstrahlengang eingekoppelt wird.

Durch den Strahlenteiler (3) und durch die Strahlenaufteilungsanordnung (4) geht eine gewisse Menge der Strahlenenergie verloren. Insbesondere in der Strahlenaufteilungsanordnung (4) verliert der Laserstrahl (2.10, 2.20) an den Kanten der Linsen (4.11) und an der Lochblende (4.3), welche gegebenenfalls gekühlt werden sollte, eine nennenswerte Energiemenge. Insbesondere tritt ein nennenswerter Verlust an Laserenergie um das Array (4.1) ein, welcher durch eine optimierte Anordnung der einzelnen Linsen (4.11) des Arrays (4.1) minimiert werden kann.

Hinter der Strahlenaufteilungsanordnung (4) ist ein optisches Vergrößerungssystem (5) angeordnet, welches die aus der Strahlenaufteilungsanordnung (4) kommenden Strahlen ((2.1₁, ..., 2.1_{N}), (2.2₁, ..., 2.2_{N})) den Abmessungen der Ablenkoptik (6) anpaßt. Die Ablenkoptik (6) ist in Fig. 5 detaillierter dargestellt.

Die Ablenkoptik (6) besteht im wesentlichen aus einer Vielzahl von Einzelelementen (6₁, ..., 6_{N}) mit verspiegelten Oberflächen (6.2), welche z.B. jeweils über drei Stellelemente (6.10, 6.20, 6.30) (z.B. Piezokristalle, Hubelemente, usw.) in drei Achsen bewegt werden kann. Die von der Ablenkoptik (6) reflektierten Strahlen ((2.1₁, ..., 2.1_{N}), (2.2₁, ..., 2.2_{N})) fallen dann auf ein Scanobjektiv (9), welches für eine Fokussierung der Strahlen ((2.1₁, ..., 2.1_{N}), (2.2₁, ..., 2.2_{N})) auf der Oberfläche (11.a) des zu bearbeitenden Werkstücks (11) sorgt. Gleichzeitig stellt der Einsatz des Scan-Objektivs (9) sicher, daß die Laserstrahlen ((2.1₁, ..., 2.1_{N}), (2.2₁, ..., 2.2_{N})) senkrecht oder zumindest nahezu senkrecht auf die Oberfläche (11a) des zu bearbeitenden Gegenstandes (11) fallen.

Vor dem Scan-Objektiv (9) ist eine Auffangmaske (14) angebracht, welche alle Strahlenbündel von ((2.1₁, ..., 2.1_{N}), (2.2₁, ..., 2.2_{N})) auffängt, welche nicht die Werkstückoberfläche (11a) erreichen sollen. Diese Auffangmaske (14) ist so gestaltet, daß sie die auf sie fallenden Strahlen ((2.1₁, ..., 2.1_{N}), (2.2₁, ..., 2.2_{N})) vernichtet. Da dies zu einer starken Erwärmung der Maske (14) führen kann, wird sie entsprechent intensiv gekühlt.

Zwischen Auffangmaske (14) und Scan-Objektiv (9) ist noch ein Strahlenteiler (7) angebracht, welcher einen kleinen Teil des auf ihn fallenden Laserlichts ((2.1₁, ..., 2.1_{N}), (2.2₁, ..., 2.2_{N})) in Richtung auf eine Kamera (8.2) ablenkt. Diese Kamera (8.2) ist eine CCD-Kamera mit einer so großen Auflösung, daß mit ihr die Position der Laserstrahlen ((2.1₁, ..., 2.1_{N}), (2.2₁, ..., 2.2_{N})) auf der Oberfläche (11a) des zu bearbeitenden Gegenstandes (11) ausreichend genau kontrolliert werden kann. Die Kamera (8.2) dient dabei der Kontrolle der Ablenkoptik (6). Wenn der Laserstrahl ((2.1₁, ..., 2.1_{N}), (2.2₁, ..., 2.2_{N})) durch das Scan-Objektiv (9) auf die Oberfläche (11a) des Werkstücks (11) gefallen ist, wird von dieser ein kleiner Teil der Laserstrahlung (2.1₁, ..., 2.1_{N}), (2.2₁, ..., 2.2_{N})) wieder zurückreflektiert. Dieses zurückreflektierte Laserlicht ((2.1'₁, ..., 2.1'_{N}), (2.2'₁, ..., 2.2'_{N})) geht wieder durch das Scan-Objektiv (9) und wird an dem Strahlteiler (7) auf eine zweite Kamera (8.1) gelenkt. Auch diese zweite Kamera (8.1) ist eine CCD-Kamera, welche eine genügend große Auflösung der zu betrachtenden Oberfläche (11a) des Werkstücks (11) besitzt. Mittels dieser Kamera (8.1) kann der Arbeitsfortschritt der Laserstrahlen ((2.1₁, ..., 2.1_{N}), (2.2₁, ..., 2.2_{N})) auf der Werkstückoberfläche (11a) kontrolliert werden und ermittelt werden, wo die Bearbeitungsstrahlen (2.1₁, ..., 2.1_{N}) tatsächlich auf die Oberfläche (11a) des Werkstücks (11) auftreffen..

Das zu bearbeitende Werkstück (11) selber befindet sich auf einem X-Y Träger (12), welcher das Bewegen des Werkstücks (11) in einer Ebene (X, Y) ermöglicht. Wenn das Werkstück (11) eine Größe hat, welche über die mögliche Bearbeitungsgröße der Bearbeitungseinrichtung (1) hinausgeht, wird dieser Träger (12) nach der beendeten Bearbeitung einer Flächeneinheit so verfahren, daß nahtlos eine benachbarte Flächeneinheit bearbeitet werden kann. Die Einstellgenauigkeit des Trägers (12) ist dabei so hoch, daß die Abweichungen der Bearbeitungspunkte vom Sollmaß genügend groß unterschritten wird.

Alle veränderbaren Elemente (2.1, 2.2, 3, 4.2, (6₁, ..., 6_{N}), 7, 12) der Materialbearbeitungseinrichtung (1) sind mit dem Eingang und dem Ausgang (13.1) einer Steuerung (13) verbunden. Außerdem sind die Kameras (8.1, 8.2) mit dem Eingang der Steuerung verbunden. Durch die Verbindung der Steuerung (13) mit den veränderbaren Elementen (2.1, 2.2, 3, 4.2, (6₁, ..., 6_{N}), 7, 12) sowie der Kameras (8.1, 8.2) erhält diese eine Meldung über den Stellzustand der einzelnen veränderbaren Elemente (2.1, 2.2, 3, 4.2, (6₁, ..., 6_{N}), 7, 12) und besitzt die Möglichkeit, diese gezielt zu verstellen. Die Steuerung (13) beinhaltet Regelkreise, welche sicherstellen, daß die Oberfläche (11a) des Werkstücks (11) in der gewünschten Art und Weise bearbeitet wird. Zudem hat die Steuerung (13) eine Eingabe (13.2), um neue Bearbeitungsparameter einzugeben. Außerdem besitzt sie mindestens einen Monitor (13.3). Durch die Steuerung (13) können die angeschlossenen Teile der Bearbeitungseinrichtung (1) eingestellt werden, bzw. die Strahlenteiler (3, 7) auf Wunsch auch aus dem Strahlengang hinausgeklappt werden.

Die Funktionsweise des MBG und deren Betrieb der an der zentralen Steuerung (13) ein- und ausschaltbaren Anlage (1) kann prinzipiell in folgenden Betriebsarten unterteilt werden:
- Stand By Betrieb;
- Prüf- bzw. Überwachungs-Betrieb;
- Einricht-Betrieb; und
- Arbeits-Betrieb.

Nach dem Einschalten geht die Anlage in den Prüf-bzw. Überwachungsbetrieb, in der alle an der Steuerung (13) angeschlossenen Komponenten auf Fehler überprüft werden. Im fehlerfreien Fall schaltet die Steuerung (13) die Anlage (1) dann in den Stand-By Betrieb, in dem alle Komponenten zwar betriebsbereit aber nicht aktiv sind.

Die Funktionsweise der Anlage wird mit der Beschreibung des Einricht- und Arbeitsbetriebes noch später erläutert.

Der von der Steuerung (13) gesteuerte Koordinatentisch (12) positioniert das Werkstück (11) bzw. dessen zu bearbeitenden Teil der Oberfläche (11a) im Einrichtbetrieb in den Arbeitsbereich unterhalb des Scanobjektives (9). Nach einer Überprüfung des Vorhandenseins des Werkstückes (11) mittels der Beobachtungsanlage (8.1) wird das auf dem Werkstück (11) gewünschte Lochbild mittels Ziel-Laserstrahlen wie folgt eingestellt:

Ausgehend von der Steuerung (13) erzeugt entweder der Arbeitslaser (2.1) den Laserstrahl (2.10), welcher durch den eingeklappten Strahlteiler (3) derart zu einem Laserstrahl abgeschwächt wird, daß er auf dem Werkstück (11) keine bearbeitende Wirkung mehr hat, sondern nur noch von den Beobachtungssystemen (8.1) und (8.2) beobachtbare Lichtpunkte erzeugt, oder es wird von der Steuerung (13) ein sog. Pilot- oder Ziellaser (2.2) aktiviert, der über den Strahlteiler (3) einen Laserstrahl (2.20) in das Bearbeitungsgerät (1) schickt, der auf dem Werkstück (11) ebenfalls nur beobachtbare Lichtpunkte erzeugt.

Der Laserstrahl (2.1) oder (2.2) wird nun durch die Mikrolinsenoptik (4), im wesentlichen bestehend aus den Mikrolinsenfeldern (4.1) und (4.2) sowie einer Feldblende (4.3), in eine Anzahl von Einzelstrahlen ((2.1₁, ..., 2.1_{N}), (2.2₁, ..., 2.2_{N})) zerlegt, entsprechend der Anzahl der Mikrolinsen (4.11, 4.21). Dies geschieht im wesentlichen durch eine geeignete Anordnung der Mikrolinsenfelder (4.1) und (4.2) zueinander. Die nun parallel zueinander verlaufenden Einzelstrahlen ((2.1₁, ..., 2.1_{N}), (2.2₁, ..., 2.2_{N})) werden vorteilhaft mittels einer Vergrößerungsoptik (5) aufgeweitet und vergrößert.

Die nun deutlich voneinander separierten aber noch in fester gegenseitiger geometrischer Anordnung sich befindenden Einzelstrahlen ((2.1₁, ..., 2.1_{N}), (2.2₁, ..., 2.2_{N})) treffen nun auf ein Kippspiegelfeld (6), welches als Ablenkeinheit dient. Die einzelnen Kippspiegel (6₁, ..., 6_{N}) sind dabei vorteilhaft im Kippspiegelhalter (6.2) derart fixiert, daß jeder einzelne Laserstrahl 2.1ₙ genau einen und stets den gleichen Kippspiegel (6ₙ) trifft, für alle n von 1 bis N Einzelspiegel.

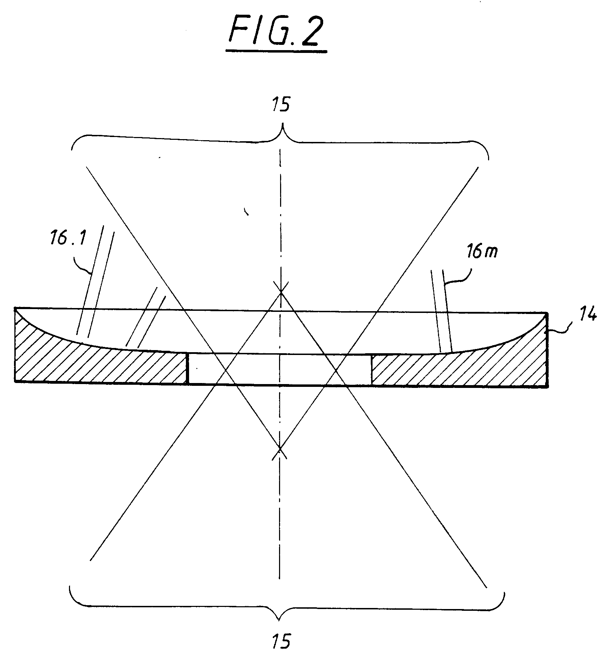

Die Elemente des Kippspiegels (6) reflektieren nun je nach ihrer Einstellung die Strahlen ((2.1₁, ..., 2.1_{N}), (2.2₁, ..., 2.2_{N})) derart, daß sie im regulären Betrieb alle durch die Öffnung der Auffangmaske (14) hindurchgehen und auf den Strahlteiler (7) treffen. Sollen gewisse Strahlen ((2.1₁, ..., 2.1_{N}), (2.2₁, ..., 2.2_{N})) nicht auf das Werkstück (11) treffen, so werden über die Steuerung (13) die entsprechenden Kippspiegel (6₁, ..., 6_{N}) derart angesteuert und verstellt, daß diese Strahlen (16.1, ..., 16.M) in die Auffangmaske (14) gelenkt werden (während die erwünschten Strahlen im Strahlenbüschel (15) hindurchgehen), siehe Figur 2.

Die Auffangmaske (14) absorbiert die auf sie treffenden Strahlen 16.m, m = 1 bis M vollständig.

Der Strahlteiler (7) leitet einerseits das Bild der von den Spiegeln (6₁, ..., 6_{N}) durch die Auffangmaske (14) hindurchkommenden Strahlen ((2.1₁, ..., 2.1_{N}), (2.2₁, ..., 2.2_{N})) in das Beobachtungssystem (8.2), welche es auswertet und das Ergebnis der Steuerung (13) übermittelt. Stimmen Soll- und Ist-Strahlbild nicht überein, kann die Steuerung (13) eine Korrektur durch geeignete Ansteuerung der entsprechenden Kippspiegel (6₁, ..., 6_{N}) vornehmen.

Die durch den Strahlteiler (7) hindurchgehenden Strahlen ((2.1₁, ..., 2.1_{N}), (2.2₁, ..., 2.2_{N})) werden in dem sogenannten Scanobjektiv (9) nun derart optisch geführt, daß sie nach Verlassen des Scanobjektivs (9) telezentrisch verlaufen und auf die Oberfläche (11a) des Werkstücks (11) fokussiert sind. Da es sich im Einrichtbetrieb nur um die energiearmen Zielstrahlen (2.2₁, ..., 2.2_{N}) handelt, erzeugen diese auf dem Werkstück (11) nun lediglich Lichtpunkte an den Orten, an denen dann später die energiereichen Strahlen (2.1₁, ..., 2.1_{N}) das Werkstück (11) bearbeiten werden. Diese Lichtpunkte werden auf der Oberfläche des Werkstücks (11) reflektiert, und das Bild dieser Lichtpunkte wird nun "rückwärts" durch das Scanobjektiv (9) und über den Strahlteiler (7) in das Beobachtungssystem (8.1) geleitet, dort ausgewertet und das Ergebnis der Steuerung (13) übermittelt. Stimmen Soll- und Ist-Strahlpunkbild auf der Oberfläche (11a) des Werkstücks (11) nicht überein, kann die Steuerung (13) eine Korrektur durch geeignete Ansteuerung der entsprechende Kippspiegel (6₁, ..., 6_{N}) vornehmen. Die absolute Richtigkeit der Lage aller Lichtpunkte kann über auf dem Werkstück (11) vorhandene Marker, welche so ausgeführt sind, daß sie vom Beobachtungssystem (8.1) erkannt werden, überprüft werden.

Stimmen Soll- und Ist-Strahlpunktbild im Rahmen der Fehlertoleranz überein, so ist der Einrichtbetrieb erfolgreich beendet und die Steuerung (13) kann in den Arbeitsbetrieb schalten (automatisch) oder geschaltet werden (manuell).

Im Einrichtbetrieb wurden die Kippspiegel (6.n) so eingestellt, daß die Strahlen des Ziellasers (2.2) auf den vorgesehenen Orten der Werkstückoberfläche (11a) liegen. Im Arbeitsbetrieb wird nun der Strahlteiler (3) aus dem Strahlengang herausgeklappt (und sofern der Ziellaser (2.2) benutzt wurde, wird dieser jetzt ausgeschaltet und der Arbeitslaser (2.1) aktiviert) und der Arbeitslaserstrahl (2.10) geht jetzt mit voller Intensität in die optische Anordnung, durchläuft den gleichen optischen Weg wie der Ziellaser (2.2) und die durch die Auffangmaske (14) passierenden Laserstrahlen (2.1₁, ..., 2.1_{N}) bearbeiten das Werkstück (11).

Nach Beendigung der Bearbeitung durch die Laserstrahlen (2.1₁, ..., 2.1_{N}) an den ausgewählten Stellen am Werkstück (11) wird wieder in den Einrichtbetrieb geschaltet und nun kann der X-Y-Koordinatentisch (12) das Werkstück (11) derart verschieben, daß die nächste zu bearbeitende Zone des Werkstückes (11) in den Einflußbereich der Laserstrahlen ((2.1₁, ..., 2.1_{N}), (2.2₁, ..., 2.2_{N})) unterhalb des Scanobjektives (9) positioniert wird. Anschließend wird wieder der Zielvorgang gestartet.

Sind im Einflußbereich der Laserstrahlen ((2.1₁, ..., 2.1_{N}), (2.2₁, ..., 2.2_{N})) mehr Stellen zu bearbeiten als Laserstrahlen ((2.1₁, ..., 2.1_{N}), (2.2₁, ..., 2.2_{N})) vorhanden sind, so werden nach Beendigung des 1. Arbeitsvorganges lediglich die entsprechenden Spiegel (6₁, ..., 6_{N}) derart angesteuert, daß die Laserstrahlen ((2.1₁, ..., 2.1_{N}), (2.2₁, ..., 2.2_{N})) an die gewünschten neuen Positionen gelenkt werden. Überzählige Laserstrahlen ((2.1₁, ..., 2.1_{N}), (2.2₁, ..., 2.2_{N})) werden von den entsprechenden Spiegeln (6₁, ..., 6_{N}) in die dafür vorgesehene Auffangmaske (14) gelenkt.

Alternativ können die Spiegel (6₁, ..., 6_{N}) auch bei laufendem Arbeitslaser (2.1) verstellt werden, es lassen sich damit kontinuierliche Strukturen auf bzw. in dem Werkstück (11) erzeugen.

Als Hauptlaser (2.1) eignet sich bei dem für Leiterplatten (11) als zu bearbeitenden Gegenstand (11) aus Polyimid-Folie mit einer durchschnittlichen Dicke von 50 µm insbesondere ein gepulster Eximer-Laser mit einer Wellenlänge von 248 nm. Ein derartiger UV-Laser (2.1) kann mit einer Pulsfrequenz von z.B. 100-200 Hz kontrolliert betrieben werden. Mit z.B.ungefähr 100 Bestrahlungen kann dann eine derartige Leiterplatte (11) durchstoßen werden, ohne daß störende thermische Effekte an der Leiterplatte (11) auftreten. Bei einer Energiedichte von 1 J/cm² je Puls erfolgt dabei eine Abtragung von 0,1-0,4 µm pro Bestrahlung. Ein typischer Lochdurchmesser liegt bei rund 50 µm Durchmesser. Der Energieverlust an der Strahlenaufteilungsanordnung (4) liegt in der Größenordnung von 50%, kann aber durch geeignete Ausgestaltung reduziert werden. Die Strahlenaufteilungsanordnung (4) erzeugt, je nach Ausgestaltung, mehrere hundert Einzellaserstrahlen((2.1₁, ..., 2.1_{N}), (2.2₁, ..., 2.2_{N})) (z.B. 30 x 30, 50 x 50 usw.), welche durch eine entsprechende Anzahl von Elementen (6₁, ..., 6_{N}) in der Ablenkungsoptik (6) individuell auf der Oberfläche (11a) des Werkstücks (11) verteilt werden können.

Die erfindungsgemäße Bearbeitungseinrichtung (1) zum Bohren bzw. Abtragen von Leiterbahnen auf Leiterplatten (11), besitzt die folgenden Vorteile:
a) Keine Beschränkung des Lochdurchmessers nach unten, d.h. Löcher bis gegen Durchmesser 5 µm möglich (abhängig von Strahlqualität und Werkstoffdicke);
b) keine feste Anordnung der Bohrlöcher, sondern variabel einstellbares Lochbild;
c) keine Laser-Maske mehr und somit auch bessere Ausnutzung des erzeugten Laser-Lichtes;
d) Verwendung unbehandelter Leiterplatten-Rohlinge, also ohne Beschichtungen mit Kupfer, Photo-Resistmaterial u.a.;
e) Entfall umweltproblematischer Ätzbäder und anderer umweltproblematischer Prozeduren;
f) geometrisch gute Lochformen, z.B. ohne Ätzlippe;
g) variable, frei programmierbare Lochbilder;
h) Lochbilder mit variabler, frei programmierbarer Lochdichte;
i) variable, frei programmierbare Lochanzahl je Leiterplatte;
j) geringe Bearbeitungszeit;
k) Strukturierbarkeit der Leiterplattenoberfläche (d.h. z.B. Erzeugung von Leiterbahnen);
l) hohe Positionsgenauigkeit der gebohrten Löcher;
m) Verwendung verschiedener Laser bzw. Laserstrahl-Wellenlänge; und
n) Einbaumöglichkeit in eine Bearbeitungsstraße, wobei die Werkstücke auf der Bearbeitungsstraße zu bzw. wieder von der Bearbeitungsstation weg befördert werden.

Auf die Strahlenaufteilungsanordnung (4) könnte im vorab beschriebenen Beispiel verzichtet werden, wenn man in die Bearbeitungseinrichtung (1) gleich mehrere Einzelstrahlen ((2.1₁, ..., 2.1_{N}), (2.2₁, ..., 2.2_{N})) eingibt. Die verwendeten Strahlen ((2.1₁, ..., 2.1_{N}), (2.2₁, ..., 2.2_{N})) brauchen keine Laserstrahlen sein, wie dies in der Figurenbeschreibung der Fall ist. Es lassen sich alle ablenkbaren Strahlen verwenden, wobei man z.B. die Strahlerzeugung bei schwer ablenkbaren Strahlen, bzw. bei Strahlen, bei welchen eine körperliche Ablenkung zuviel Energieverlust bedeutet, direkt an oder auf die Ablenkanordnung (6) verlegen kann. Dies kann z.B. die Düse bei Wasserstrahlen sein oder eine Laserdiode bei Laserstrahlen. Letztendlich kann eine Minimalrealisierung des erfindungsgemäßen Gedankens in einer bzw. mehreren Anordnungen zur Erzeugung der Bearbeitungsstrahlen (2.1₁, ..., 2.1_{N}) sowie in einer, für die jeweiligen Strahlen geeigneten Anordnung (6) zur Lenkung dieser Strahlen bestehen.

Insbesondere die vorab beschriebene Verwendung von Laserstrahlen (2.10, 2.20) läßt viele Möglichkeiten zur Erzeugung von Einzelstrahlen ((2.1₁, ..., 2.1_{N}), (2.2₁, ..., 2.2_{N})) zu, welche direkt oder im nachhinein eine zueinander parallele Ausrichtung mit einem gewissen Abstand zueinander erhalten. Die einzelnen Strahlen ((2.1₁, ..., 2.1_{N}), (2.2₁, ..., 2.2_{N})) können auf vielfältige Art und Weise (Gitter, Strahlenteiler, ...) erzeugt und später geformt werden. Die im Beispiel erwähnte und erläuterte Erzeugungsweise ist momentan lediglich die einfachste und kostengünstigste. Insbesondere ein Laserdiodenarray (d.h. flächig angeordnete Laserdioden) mit geeigneter Frequenz und Energiedichte bei ausreichendem Querschnitt dürfte zukünftig eine konkurierende Art der Erzeugung der Bearbeitungsstrahlen ((2.1₁, ..., 2.1_{N}), (2.2₁, ..., 2.2_{N})) sein. Auf die Aufweitungsoptik (5) nach der Strahlaufteilungsanordnung (4) kann verzichtet werden, wenn die aus der Strahlaufteilungsanordnung (4) austretenden Bearbeitungsstrahlen (2.1₁, ..., 2.1_{N}) schon den gewünschten Querschnitt aufweisen.

Auf die Auffangmaske (14) kann verzichtet werden, wenn die Bearbeitungsstrahlen (2.1₁, ..., 2.1_{N}) von der Ablenkanordnung (6) außerhalb der zu bearbeitenden Oberfläche (11a) auf ein dafür geeignetes Gebiet gelenkt werden können.

Auf eine der beiden Strahlkontroll-Kameras (8.1, 8.2) kann verzichtet werden, wenn man zum einen ausreichend Zeit bei der Bearbeitung hat oder Fehlschüsse bei der Bearbeitung zuläßt, bzw. sicherstellen kann, daß die Strahlablenkung (6) immer in gewünschter Art und Weise erfolgt (Kontrolle der Ablenkanordnung).

Auf das Scan-Objektiv (9) kann verzichtet werden, wenn man am Rand auch eine schräge Materialbearbeitung zuläßt bzw. die Abmessungen der zu bearbeitenden Oberfläche (11a) dies zuläßt.

Auf den x-y-Werkzeugtisch (12) kann verzichtet werden, wenn die zu bearbeitende Oberfläche (11a) nie größer sein kann als die Auslenkmöglichkeiten der Ablenkanordnung (6).

Auch die Ablenkanordnung (6) kann in der Praxis anders aussehen, auch wenn man Laserstrahlen ((2.1₁, ..., 2.1_{N}), (2.2₁, ..., 2.2_{N})) verwendet. Anstelle der spiegelnden Flächen kann man auch die anderen bekannten Arten der Strahlablenkung (bei Laserstrahlen z.B. Planlinsenpaar oder Drehkeilpaar) verwenden, wobei die Verwendung von brechenden Körpern einen größeren Energieverlust bedeutet.

Auf die Verwendung des Anzeigelasers (2.2) kann verzichtet werden, wenn der Arbeitslaser (2.1) zur Strahlpositionsbestimmung auf der Werkstückoberfläche (11a) durch den Strahlteiler (3) genügend abgeschwächt werden kann.

Die verwendeten Strahlenquerschnitte brauchen nicht wie dargestellt rund sein, sondern können jede gewünschte und nach dem bekannten Stand der Technik mögliche Form haben.

Das Scan-Objektiv (9) braucht nicht unbedingt aus zwei hintereinander angeordneten Linsen (9.1, 9.2) bestehen, sondern die Linsenanzahl kann sowohl in der Bestrahlungsachse als auch in den dazu senkrecht stehenden Koordinatenachsen variieren.

Auf die Strahlenaufteilungsanordnung (4) kann auch verzichtet werden, wenn diese Aufgabe durch z.B. die Ablenkungsanordnung (6) übernommen wird.

## Patentansprüche

1. Materialbearbeitungseinrichtung (1) zur Bearbeitung einer Oberfläche (11a) eines Werkstücks (11) unter Verwendung von mehreren diskreten Bearbeitungsstrahlen (2.1₁, ..., 2.1_{N}), bei welcher jeder Bearbeitungsstrahl (2.1₁, ..., 2.1_{N}) durch ein ihm zugeordnetes Element (6₁, ..., 6_{N}) einer Ablenkungsanordnung (6) gelenkt wird und welche die gleichzeitige Bearbeitung möglicherweise unterschiedliche Punkte auf einer Oberfläche (11a) eines zu bearbeitenden Gegenstandes (11) ermöglicht, dadurch gekennzeichnet, daß die Lage der einzelnen Elemente (6₁, ..., 6_{N}) der Ablenkungsanordnung (6) durch eine Steuerung (13) gezielt veränderbar ist und daß die einzelnen Elemente (6₁, ..., 6_{N}) der Ablenkoptik (6) jeweils diskret zumindest in einer Koordinatenrichtung in ihrer Lage verstellbar sind.

2. Materialbearbeitungseinrichtung nach Anspruch 1, dadurch gekennzeichnet, daß die Bearbeitungsstrahlen (2.1₁, ..., 2.1_{N}) vor der Ablenkanordnung (6) zueinander parallel angeordnet sind.

3. Materialbearbeitungseinrichtung nach Anspruch 1 oder 2, dadurch gekennzeichnet, daß die Drehpunkte der Elemente (6₁, ..., 6_{N}) der Ablenkeinrichtung (6) alle auf einer durchaus gewölbten Ebene angeordnet sind.

4. Materialbearbeitungseinrichtung nach einem der Ansprüche 1 - 3, dadurch gekennzeichnet, daß die auf die Elemente (6₁, ..., 6_{N}) der Ablenkungsanordnung (6) fallenden Bearbeitungsstrahlen (2.1₁, ..., 2.1_{N}) zu ihrem jeweiligen Hauptstrahl achsenparallel sind.

5. Materialbearbeitungseinrichtung nach einem der Ansprüche 1 - 4, dadurch gekennzeichnet, daß die von den Elementen (6₁, ..., 6_{N}) der Ablenkungsanordnung (6) kommenden Bearbeitungsstrahlen (2.1₁, ..., 2.1_{N}) zu ihrem jeweiligen Hauptstrahl achsenparallel sind.

6. Materialbearbeitungseinrichtung nach einem der Ansprüche 1 - 5, dadurch gekennzeichnet, daß in der Ablenkungsanordnung (6) als ablenkende Elemente (6₁, ..., 6_{N}) beugende und/oder reflektierende Elemente (6₁, ..., 6_{N}) verwendet sind.

7. Materialbearbeitungseinrichtung nach einem der Ansprüche 1 - 5, dadurch gekennzeichnet, daß die Ablenkungsanordnung (6) aus reflektierenden Elementen (6) aufgebaut ist.

8. Materialbearbeitungseinrichtung nach Anspruch 8, dadurch gekennzeichnet, daß das reflektierende Element (6₁, ..., 6_{N}) ein Spiegel ist.

9. Materialbearbeitungseinrichtung nach einem der Ansprüche 6 - 8, dadurch gekennzeichnet, daß die Ablenkungsanordnung (6) aus Segmenten (6₁, ..., 6_{N}) aufgebaut ist.

10. Materialbearbeitungseinrichtung nach Anspruch 9, dadurch gekennzeichnet, daß die Segmente (6₁, ..., 6_{N}) einzeln beweglich in oder um zumindest einer Koordinatenachse sind.

11. Materialbearbeitungseinrichtung nach einem der Ansprüche 9 oder 10, dadurch gekennzeichnet, daß die Segmente (6₁, ..., 6_{N}) in oder um zwei Koordinatenachsen beweglich sind.

12. Materialbearbeitungseinrichtung nach einem der Ansprüche 6 - 11, dadurch gekennzeichnet, daß die Oberfläche (6.2) des reflektierenden Elements (6₁, ..., 6_{N}) plan ist.

13. Materialbearbeitungseinrichtung nach einem der Ansprüche 1 - 12, dadurch gekennzeichnet, daß hinter der Ablenkungseinrichtung (6) eine abbildende Optik (9) angeordnet ist.

14. Materialbearbeitungseinrichtung nach einem der Ansprüche 1 - 13, dadurch gekennzeichnet, daß die Bearbeitungsstrahlen (2.1₁, ..., 2.1_{N}) aus Laserlicht sind.

15. Materialbearbeitungseinrichtung nach Anspruch 14, dadurch gekennzeichnet, daß hinter dem Laser (2.1) ein Strahlhomogenisierer (2.3) angebracht ist.

16. Materialbearbeitungseinrichtung nach einem der Ansprüche 14 oder 15, dadurch gekennzeichnet, daß der Laser (2.1) im gepulsten Betrieb verwendet ist.

17. Materialbearbeitungseinrichtung nach einem der Ansprüche 14 - 16, dadurch gekennzeichnet, daß die Intensität eines Laserblitzes so gewählt ist, daß nur ein Teil des Materials abgetragen wird.

18. Materialbearbeitungseinrichtung nach einem der Ansprüche 1 - 17, dadurch gekennzeichnet, daß mindestens eine Strahlaufteilungsanordnung (4) vorhanden ist, welche zumindest einen Bearbeitungsstrahl (2.1) in mehrere diskrete Bearbeitungsteilstrahlen (2.1₁, ..., 2.1_{N}) aufteilt, und daß die Strahlaufteilungsanordnung (4) vor der steuerbare Ablenkungsanordnung (6) angeordnet ist.

19. Materialbearbeitungseinrichtung nach Anspruch 18, dadurch gekennzeichnet, daß die Strahlaufteilungsanordnung (4) aus mehreren Linsen (4.11, 4.21) aufgebaut ist.

20. Materialbearbeitungseinrichtung nach einem der Ansprüche 18 oder 19, dadurch gekennzeichnet, daß die Strahlaufteilungsanordnung (4) aus zwei Arrays (4.1, 4.2) aufgebaut ist, welche dafür sorgen, daß nach der Strahlaufteilungsanordnung (4) die einzelnen Strahlen ((2.1₁, ..., 2.1_{N}), (2.2₁, ..., 2.2_{N})) einen gewissen Abstand zueinander haben.

21. Materialbearbeitungseinrichtung nach einem der Ansprüche 18 - 20, dadurch gekennzeichnet, daß die Strahlaufteilungsanordnung (4) aus einem Array (4.1, 4.2) aufgebaut ist, welches eine zweidimensionale Verteilung der erzeugten Teilstrahlen ((2.1₁, ..., 2.1_{N}), (2.2₁, ..., 2.2_{N})) erzeugt.

22. Materialbearbeitungseinrichtung nach einem der Ansprüche 18 - 21, dadurch gekennzeichnet, daß hinter der Strahlenaufteilungsanordnung (4) ein optisches Vergrößerungssystem (5) angeordnet ist.

23. Materialbearbeitungseinrichtung nach einem der Ansprüche 1 - 22, dadurch gekennzeichnet, daß die Materialbearbeitungseinrichtung zur Bearbeitung von Leiterplatten verwendet wird.

24. Materialbearbeitungseinrichtung nach einem der Ansprüche 1 - 23, dadurch gekennzeichnet, daß der Strahlenverlauf der Teilstrahlen ((2.1₁, ..., 2.1_{N}), (2.2₁, ..., 2.2_{N})) vor der zu bearbeitenden Werkstoberfläche ein telezentrischer Verlauf ist.

25. Materialbearbeitungseinrichtung nach einem der Ansprüche 1 - 24, dadurch gekennzeichnet, daß die Teilstrahlen ((2.1₁, ..., 2.1_{N}), (2.2₁, ..., 2.2_{N})) das zu bearbeitende Teil unter einem Winkel α treffen, welcher möglichst klein ist, vorteilhafter weise kleiner als 5°.

## Claims

1. Material machining arrangement (1) for machining a surface (11a) of a workpiece (11) by utilizing a plurality of discrete machining beams (2.1₁, to 2.1_{N}), each one of the machining beams (2.1₁ to 2.1_{N}) being deflected by a corresponding element (6₁ to 6_{N}) of a deflecting device (6), said arrangement making possible the simultaneous machining of different points on a surface (11a) of the workpiece (11) to be machined, characterized in that the position of the individual elements (6₁ to 6_{N}) of the deflecting device (6) can be changed in a targeted manner by a control (13) and, the individual elements (6₁ to 6_{N}) of the deflecting optic (6) can each be changed discretely in their positions in at least one coordinate direction.

2. Material machining arrangement of claim 1, characterized in that the machining beams (2.1₁ to 2.1_{N}) are arranged parallel to each other forward of the deflecting device (6).

3. Material machining arrangement of claim 1 or 2, characterized in that the rotation points of the elements (6₁ to 6_{N}) of the deflecting device (6) are all arranged on an arcuate plane.

4. Material machining arrangement of one of the claims 1 to 3, characterized in that the machining beams (2.1₁ to 2.1_{N}), which are incident upon the elements (6₁ to 6_{N}) of the deflecting device (6), are axis-parallel to their particular main beam.

5. Material machining arrangement of one of the claims 1 to 4, characterized in that the machining beams (2.1₁ to 2.1_{N}), which come from the elements (6₁ to 6_{N}) of the deflecting device (6), are each parallel to the axis of the main beam.

6. Material machining arrangement of one of the claims 1 to 5, characterized in that diffracting and/or reflecting elements (6₁ to 6_{N}) are used in the deflecting device (6) as deflecting elements (6₁ to 6_{N}).

7. Material machining arrangement of one of the claims 1 to 5, characterized in that the deflecting device (6) is made up of reflecting elements (6).

8. Material machining arrangement of claim 7, characterized in that the reflecting element (6₁ to 6_{N}) is a mirror.

9. Material machining arrangement of one of the claims 6 to 8, characterized in that the deflecting device 6 is made up of segments (6₁ to 6_{N}).

10. Material machining arrangement of claim 8, characterized in that the segments (6₁ to 6_{N}) are individually movable in or about at least one coordinate axis.

11. Material machining arrangement of one of the claims 9 or 10, characterized in that the segments (6₁ to 6_{N}) are movable in or about two coordinate axes.

12. Material machining arrangement of one of the claims 6 to 11, characterized in that the surface (6.2) of the reflecting element (6₁ to 6_{N}) is planar.

13. Material machining arrangement of one of the claims 1 to 12, characterized in that an imaging optic (9) is mounted rearward of the deflecting device (6).

14. Material machining arrangement of one of the claims 1 to 13, characterized in that the machining beams (2.1₁ to 2.1_{N}) are of laser light.

15. Material machining arrangement of claim 14, characterized in that a beam homogenizer (2.3) is arranged rearward of the laser (2.1).

16. Material machining arrangement of one of the claims 14 or 15, characterized in that the laser (2.1) is used in pulsed operation.

17. Material machining arrangement of one of the claims 14 to 16, characterized in that the intensity of a laser flash is so selected that only a portion of the material is removed.

18. Material machining arrangement of one of the claims 1 to 17, characterized in that at least one beam divider device (4) is provided which divides at least one machining beam (2.1) into several discrete machining component beams (2.1₁ to 2.1_{N}) and, that the beam divider device (4) is mounted forward of the controllable deflecting device (6).

19. Material machining arrangement of claim 18, characterized in that beam divider device (4) is made up of several lenses (4.11, 4.21).

20. Material machining arrangement of one of the claims 18 or 19, characterized in that the beam divider device (4) is made up of two arrays (4.1, 4.2) which ensure that the individual beams ((2.1₁ to 2.1_{N}), (2.2₁ to 2.2_{N})) have a specific spacing to each other downstream of the beam divider device (4).

21. Material machining arrangement of one of the claims 18 to 20, characterized in that the beam divider device (4) is made up of an array (4.1, 4.2) which generates a two-dimensional distribution of the generated component beams ((2.1₁ to 2.1_{N}), (2.2₁ to 2.2_{N})).

22. Material machining arrangement of one of the claims 18 to 21, characterized in that an optical magnification system (5) is mounted rearward of the beam divider device (4).

23. Material machining arrangement of one of the claims 1 to 22, characterized in that the material machining arrangement is used for machining printed circuit boards.

24. Material machining arrangement of one of the claims 1 to 23, characterized in that the beam trace of the component beams ((2.1₁ to 2.1_{N}), (2.2₁ to 2.2_{N})) has a telecentric trace forward of the workpiece surface to be machined.

25. Material machining arrangement of one of the claims 1 to 24, characterized in that the component beams ((2.1₁ to 2.1_{N}), (2.2₁ to 2.2_{N})) are incident upon the portion to be machined at an angle (α) which is as small as possible and is preferably less than 5°.

## Revendications

1. Dispositif d'usinage de matériaux (1) servant à confectionner la surface (11a) d'une pièce à usiner (11) au moyen de plusieurs faisceaux d'usinage distincts (2.1₁, ...., 2.1_{N}), qui associe à chaque faisceau d'usinage (2.1₁, ...., 2.1_{N}) un élément (6₁, ...., 6_{N}) d'un dispositif de déviation (6) qui le réoriente, et qui permet de procéder à un usinage simultané sur des points dont la position peut varier au niveau d'une surface (11a) d'un objet à usiner (11), caractérisé en ce que la position des différents éléments (6₁, ...., 6_{N}) du dispositif de déviation (6) peut être modifiée avec précision par une unité de commande (13) et que les différents éléments (6₁, ...., 6_{N}) de l'optique de déviation (6) sont réglables individuellement dans un axe des coordonnées au moins.

2. Dispositif d'usinage de matériaux selon la revendication 1, caractérisé en ce que les faisceaux d'usinage (2.1₁, ...., 2.1_{N}) sont parallèles les uns aux autres en amont du dispositif de déviation (6).

3. Dispositif d'usinage de matériaux selon la revendication 1 ou 2, caractérisé en ce que les centres de rotation des éléments (6₁, ...., 6_{N}) du dispositif de déviation (6) sont tous disposés sur un plan incurvé.

4. Dispositif d'usinage de matériaux selon l'une des revendications 1 à 3, caractérisé en ce que les faisceaux d'usinage (2.1₁, ...., 2.1_{N}) qui rencontrent les éléments (6₁, ...., 6_{N}) du dispositif de déviation (6) sont orientés parallèlement à l'axe de leur rayon central respectif.

5. Dispositif d'usinage de matériaux selon l'une des revendications 1 à 4, caractérisé en ce que les faisceaux d'usinage (2.1₁, ...., 2.1_{N}) en provenance des éléments (6₁, ...., 6_{N}) du dispositif de déviation (6) sont orientés parallèlement à l'axe de leur rayon central respectif.

6. Dispositif d'usinage de matériaux selon l'une des revendications 1 à 5, caractérisé en ce que les éléments (6₁, ...., 6_{N}) composant le dispositif de déviation (6) sont des éléments diffractants et/ou des éléments réfléchissants (6₁, ...., 6_{N}).

7. Dispositif d'usinage de matériaux selon l'une des revendications 1 à 5, caractérisé en ce que le dispositif de déviation (6) se compose d'éléments réfléchissants (6).

8. Dispositif d'usinage de matériaux selon la revendication 7, caractérisé en ce que l'élément réfléchissant (6₁, ...., 6_{N}) est un miroir.

9. Dispositif d'usinage de matériaux selon l'une des revendications 6 à 8, caractérisé en ce que le dispositif de déviation (6) se compose de segments (6₁, ...., 6_{N}).

10. Dispositif d'usinage de matériaux selon la revendication 9, caractérisé en ce que les segments (6₁, ...., 6_{N}) sont mobiles individuellement dans ou autour d'un axe de coordonnées au moins.

11. Dispositif d'usinage de matériaux selon l'une des revendications 9 et 10, caractérisé en ce que les segments (6₁, ...., 6_{N}) sont mobiles dans ou autour de deux axes de coordonnées.

12. Dispositif d'usinage de matériaux selon l'une des revendications 6 à 11, caractérisé en ce que la surface (6.2) de l'élément réfléchissant (6₁, ...., 6_{N}) est plane.

13. Dispositif d'usinage de matériaux selon l'une des revendications 1 à 12, caractérisé en ce qu'une optique de reproduction (9) est disposée en aval du dispositif de déviation (6).

14. Dispositif d'usinage de matériaux selon l'une des revendications 1 à 13, caractérisé en ce que les faisceaux d'usinage (2.1₁, ...., 2.1_{N}) sont formés de lumière laser.

15. Dispositif d'usinage de matériaux selon la revendication 14, caractérisé en ce qu'un homogénéisateur de faisceau (2.3) est adapté en aval du laser (2.1).

16. Dispositif d'usinage de matériaux selon l'une des revendications 14 et 15, caractérisé en ce que le laser (2.1) fonctionne en mode impulsionnel.

17. Dispositif d'usinage de matériaux selon l'une des revendications 14 à 16, caractérisé en ce que l'intensité du flash laser peut être choisie de manière à n'enlever qu'une partie du matériau exposé.

18. Dispositif d'usinage de matériaux selon l'une des revendications 1 à 17, caractérisé en ce qu'elle comporte au moins un dispositif de division de faisceau (4) qui subdivise au moins un faisceau d'usinage (2.1) en plusieurs faisceaux d'usinage parties distincts (2.1₁, ...., 2.1_{N}) et que ledit dispositif de division de faisceau (4) est disposé en amont du dispositif de déviation orientable (6).

19. Dispositif d'usinage de matériaux selon la revendication 18, caractérisé en ce que le dispositif de division de faisceau (4) se compose de plusieurs lentilles (4.11, 4.21).

20. Dispositif d'usinage de matériaux selon l'une des revendications 18 et 19, caractérisé en ce que le dispositif de division de faisceau (4) se compose de deux groupes de lentilles (4.1, 4.2) qui font en sorte que les différents faisceaux ((2.1₁, ...., 2.1_{N}), (2.2₁, ...., 2.2_{N})) présentent un certain écart les uns par rapport aux autres à l'issue du dispositif de division de faisceau (4).

21. Dispositif d'usinage de matériaux selon l'une des revendications 18 à 20, caractérisé en ce que le dispositif de division de faisceau (4) se compose d'un assemblage (4.1, 4.2) qui provoque une répartition en deux dimensions des faisceaux parties engendrés ((2.1₁, ...., 2.1_{N}), (2.2₁, ...., 2.2_{N})).

22. Dispositif d'usinage de matériaux selon l'une des revendications 18 à 21, caractérisé en ce qu'un système d'agrandissement optique (5) est disposé en aval du dispositif de division de faisceau (4).

23. Dispositif d'usinage de matériaux selon l'une des revendications 1 à 22, caractérisé en ce que le dispositif d'usinage de matériaux est utilisé pour l'usinage de plaquettes à circuits imprimés.

24. Dispositif d'usinage de matériaux selon l'une des revendications 1 à 23, caractérisé en ce que les faisceaux partiels ((2.1₁, ...., 2.1_{N}), (2.2₁, ...., 2.2_{N})) évoluent selon un trajet télécentrique en amont de la surface à soumettre à l'usinage.

25. Dispositif d'usinage de matériaux selon l'une des revendications 1 à 24, caractérisé en ce que les faisceaux parties ((2.1₁, ...., 2.1_{N}), (2.2₁, ...., 2.2_{N})) frappent la pièce à usiner sous un angle α aussi petit que possible qui est avantageusement inférieur à 5°.
